# FASCICULE DE BREVET EUROPEEN

(11) **EP 1 010 202 B1**
(45) Date de publication et mention de la délivrance du brevet: **08.01.2003**
(21) Numéro de dépôt: 98936480.7
(22) Date de dépôt: 08.07.1998
(51) Int. Cl.: H01L 21/762

(54) **PROCEDE DE MINIMISATION DE L'EFFET DE COIN PAR DENSIFICATION DE LA COUCHE ISOLANTE**
VERFAHREN ZUR MINIMIERUNG DES RANDEFFEKTS DURCH VERDICHTEN DER ISOLATIONSSCHICHT
METHOD FOR MINIMISING CORNER EFFECT BY DENSIFYING THE INSULATING LAYER

(30) Priorité: 08.07.1997 FR 9708642
(43) Date de publication de la demande: 21.06.2000
(73) Titulaire: FRANCE TELECOM, 75015 Paris (FR)
(72) Inventeur: SCHIAVONE, Patrick, F-38190 Villard-Bonnot (FR); GAILLARD, Frédéric, F-38500 Voiron (FR)
(74) Mandataire: Casalonga, Axel
(86) Numéro de dépôt international: FR9801475
(87) Numéro de publication internationale: WO99003148

(56) Documents cités:
- EP-A- 0 199 965
- EP-A- 0 690 493
- EP-A- 0 776 036
- GAILLARD F ET AL: "SILICON DIOXIDE CHEMICAL VAPOR DEPOSITION USING SILANE AND HYDROGEN PEROXIDE" JOURNAL OF VACUUM SCIENCE AND TECHNOLOGY: PART B, vol. 14, no. 4, 1 juillet 1996, pages 2767-2769, XP000622162
- SEWARD T P III ET AL: "Densification of synthetic fused silica under ultraviolet irradiation" FOURTEENTH UNIVERSITY CONFERENCE ON GLASS SCIENCE. PRACTICAL IMPLICATIONS OF GLASS STRUCTURE, BETHLEHEM, PA, USA, 17-20 JUNE 1997, vol. 222, pages 407-414, XP002059238 ISSN 0022-3093, JOURNAL OF NON-CRYSTALLINE SOLIDS, DEC. 1997, ELSEVIER, NETHERLANDS

## Description

L'invention concerne les technologies de fabrication de circuits intégrés et plus particulièrement la réalisation de transistors MOS.

Dans les technologies actuelles de faibles dimensions, on utilise de préférence pour l'isolement latéral des zones actives et notamment l'isolement latéral des transistors MOS, des techniques d'isolement par tranchées peu profondes (STI) (ou BOX). Ces techniques combinent conjointement la gravure de tranchées disposées latéralement par rapport aux futures zones actives, et le remplissage desdites tranchées avec un matériau isolant tel qu'un oxyde de silicium. Cette couche d'isolant est aplanie avant le dépôt de la grille lors de la réalisation de transistors MOS. Le remplissage des tranchées s'effectue généralement par dépôt du matériau isolant sur une couche d'oxyde thermique réalisée précédemment.

Les opérations d'oxydation et de désoxydation sacrificielles successives du procédé d'isolement avant le dépôt de la grille, ont tendance à dégager les zones dites de "coin" des futures zones actives. On appelle zone de "coin" la transition abrupte entre une zone d'isolement et une zone active. Leur mise à nu s'accentue sensiblement lorsque, lors de l'opération d'aplanissement de la couche d'isolant remplissant les tranchées, une partie de l'oxyde isolant est consommée.

L'apparition de ces zones de "coin" favorise une concentration des lignes de champs à l'angle supérieur de la zone active et donc la formation d'un transistor parasite. On observe alors la formation de trois transistors, le transistor central principal et deux transistors parasites de "coin". Ces derniers possèdent une tension de seuil plus faible que celle du transistor principal et conduisent donc avant ce dernier. Ce phénomène entraîne une augmentation de la consommation de courant avant le fonctionnement effectif du transistor.

Afin d'améliorer les qualités électriques de l'isolement latéral et notamment la concentration des lignes de champ vers ces zones de coin à l'angle supérieure de la zone active, une des solutions possibles est de maintenir l'oxyde au même niveau que la zone active. L'oxyde déposé doit donc avoir une densité voisine de celle de la silice. Compte-tenu de la structure des oxydes de silicium (structure xérogel) utilisés pour le remplissage de tranchées peu profondes, il est nécessaire de les recuire à très haute température (> 1200°C) ou d'utiliser une autre technique à très faible bilan thermique pour les densifier.

Il convenait donc de déterminer un moyen pour supprimer ou tout au moins pour sensiblement diminuer cet effet de "coin" parasite.

Les inventeurs ont maintenant découvert qu'il était possible de réduire sensiblement l'effet de "coin" qui entachait les propriétés électriques des transistors MOS, sans induire d'inconvénients supplémentaires dans la réalisation desdits transistors.

Ainsi, l'invention a pour objet un procédé de minimisation de l'effet de "coin" dans des tranchées peu profondes d'oxyde de silicium permettant l'isolement latéral des zones actives, dont la caractéristique essentielle est la densification de la couche d'oxyde de silicium déposée dans lesdites tranchées latérales.

La densification de ces oxydes de silicium s'effectue selon l'invention par irradiation de ladite couche isolante sous un rayonnement lumineux de faible longueur d'onde. L'utilisation de cette technique permet de maintenir un faible bilan thermique de l'opération.

Cette technique présente l'avantage supplémentaire de pouvoir être mise en oeuvre et utilisée aisément au sein d'un procédé de fabrication de transistors MOS.

Selon un aspect préférentiel de l'invention, l'irradiation de la couche d'oxyde isolant s'effectue sous un rayonnement lumineux d'une longueur d'onde inférieure ou égale à 200 nm avec une quantité de photons au cm² supérieure à 10¹⁹ et une énergie au moins égale à 9 eV.

Plus particulièrement, le rayonnement lumineux utilisé à une longueur d'onde d'environ 100 nm.

La densification de la couche d'oxyde déposée dans les tranchées d'isolement peut être réalisée directement après le dépôt de la couche d'isolant, ou encore, après l'étape d'aplanissement de ladite couche. Afin d'éviter un dégagement de la zone de "coin" lors de l'aplanissement de l'oxyde isolant déposé dans les tranchées, la densification se fait préférentiellement directement après le dépôt de l'oxyde dans les tranchées peu profondes.

D'autres avantages et caractéristiques de l'invention apparaîtront à l'examen de la description détaillée des modes de mise en oeuvre et de réalisation de l'invention, nullement limitatifs, et des dessins annexés, sur lesquels :
la figure 1 illustre schématiquement un transistor MOS présentant un effet de "coin";
la figure 2 illustre schématiquement un dispositif selon l'invention avant le dépôt de la grille.

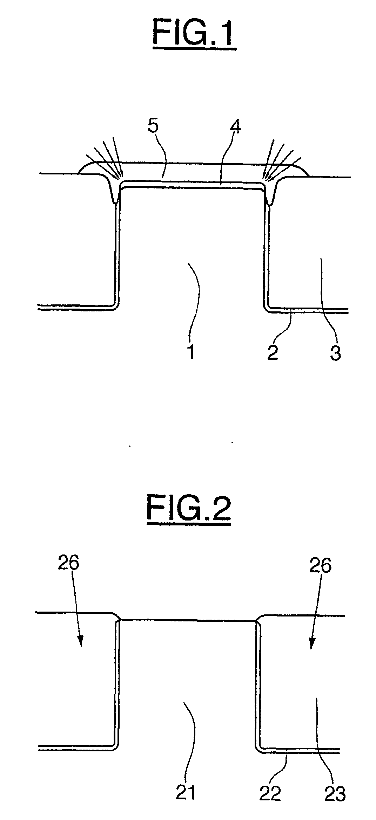

Tel qu'illustré à la figure 1, on a réalisé un isolement latéral d'une zone active 1 selon les méthodes de l'art antérieur, puis déposé une grille 5 sur ladite zone active en vue de réaliser un transistor MOS.

On réalise de façon classique des tranchées peu profondes disposées latéralement par rapport à une zone prédéterminée destinée à former ultérieurement une zone active 1 du dispositif semi-conducteur. On forme ensuite une fine couche d'oxyde thermique 2 tapissant les flancs et le fond de la tranchée qui constitue une bonne interface entre le substrat de la zone active et l'isolant. L'étape ultérieure consiste à déposer dans les tranchées une couche d'oxyde de silicium 3 afin de remplir lesdites tranchées. On protège généralement les zones actives lors de ce procédé par un masque de protection déposé à la surface desdites zones actives. C'est la raison pour laquelle, après aplanissement de la couche d'oxyde et suppression du masque de protection des zones actives, la hauteur de la couche d'oxyde 3 déposée dans les tranchées latérales est légèrement supérieure à la hauteur de la zone active 1.

Ces différentes étapes de la fabrication du dispositif semi-conducteur ont dégagé les angles supérieurs de la zone active 1. Sur ce dispositif semi-conducteur, on réalise une fine couche d'oxyde de grille 4 sur laquelle est déposée la grille 5 avec débordement sur les zones d'isolement. On poursuit ensuite le procédé de fabrication du transistor MOS de manière classique. Lorsque l'on active le transistor obtenu, on observe une concentration des lignes de champ dans les zones de "coin" entraînant la formation de deux transistors parasites situés aux deux extrémités de la grille.

La figure 2 illustre le dispositif semi-conducteur obtenu selon le procédé de l'invention à l'étape précédant immédiatement la formation de l'oxyde de grille et le dépôt de celle-ci. On constate que les zones de "coin" n'ont pas été dégagées contrairement à la figure précédente.

Après la gravure des tranchées 26 disposées latéralement par rapport aux futures zones actives 21 (dont une seule est représentée sur la figure) par un procédé classique, une couche d'oxyde thermique 22 est formée tapissant les parois et le fond des tranchées ainsi que la surface des zones actives 21. On dépose ensuite de manière classique, par exemple par CVD, au moins une couche isolante d'oxyde de silicium 23 dans les tranchées 26. L'épaisseur de cette couche est telle que toutes les tranchées de la plaquette soient parfaitement remplies.

Habituellement, les futures zones actives sont recouvertes d'un masque de protection lors du procédé d'isolement afin de préserver intacte leur surface. L'épaisseur de l'isolant déposé dans les tranchées est alors telle qu'elle est au moins égale à la hauteur de la zone active (profondeur des tranchées) recouverte de l'oxyde thermique et du masque de protection.

Selon un mode de réalisation de l'invention, l'étape suivante constitue l'élément essentiel de l'invention. Il s'agit de la densification de la couche d'oxyde de silicium 23 déposée dans les tranchées 26.

Selon un autre mode de réalisation de l'invention, la couche isolante d'oxyde de silicium 23 est, préalablement à sa densification, aplanie de manière classique, par exemple par polissage mécano-chimique. L'étape de densification est alors réalisée sur la couche d'oxyde aplanie.

Quel que soit le moment où la densification de la couche isolante d'oxyde de silicium 23 est mise en oeuvre, celle-ci peut être réalisée, selon un aspect particulier de l'invention, par irradiation de ladite couche sous un rayonnement lumineux de faible longueur d'ond (ex.: faisceau laser ou lampe à mercure).

Le rayonnement lumineux utilisé pour cette irradiation a une longueur d'onde inférieure ou égale à 200 nm avec une quantité de photons en cm² de 10¹⁹ et une énergie au moins égale à 9 eV. On obtient une densification optimale lorsque la longueur d'onde est d'environ 100 nm. La couche d'oxyde de silicium 23 déposée dans les tranchées 26 est ainsi transformée en une couche isolante plus dense de structure proche de celle de la silice pure.

Après l'étape de densification, le procédé d'isolement et de réalisation de transistor MOS se poursuit de manière classique. La figure 2 illustre schématiquement l'état du dispositif obtenu après aplanissement de la couche d'oxyde, retrait des masques de protection des futures zones actives et désoxydation des surfaces. Une future zone active 21 est ainsi isolée latéralement de part et d'autre par des tranchées 26 peu profondes. Ces tranchées sont tapissées d'une couche d'oxyde thermique 22 et remplies par au moins une couche isolante aplanie 23 d'oxyde de silicium densifié de densité proche de celle de l'oxyde thermique.

Le procédé de fabrication du transistor se poursuit ensuite de manière classique.

L'effet agressif des étapes successives d'aplanissement de la couche isolante remplissant les tranchées, de retrait des masques de protection, de désoxydation de la surface des futures zones actives, etc ..., est ainsi minimisé. Les zones de "coin" des futures zones actives ne sont plus découvertes comme elles l'étaient précédemment. Lorsque l'on active un transistor dont les zones isolantes par tranchées peu profondes ont été densifiées selon le procédé de l'invention, on n'observe plus les concentrations de lignes de champ dans les zones de "coin". L'effet parasite dit de "coin" est minimisé et les propriétés électriques des transistors MOS ainsi réalisés sont significativement améliorées sans par ailleurs induire d'autres défauts ou inconvénients aux dispositifs fabriqués.

Le procédé de l'invention a, en outre, l'avantage de pouvoir être aisément mis en oeuvre dans une ligne de fabrication de transistors MOS en utilisant un appareillage classique.

## Revendications

1. Procédé de minimisation d'effet de "coin" dans des tranchées peu profondes (26) d'oxyde de silicium permettant l'isolement latéral de zones actives (21), **caractérisé en ce qu'**après le dépôt d'une couche d'oxyde de silicium (23) dans les tranchées (26), on densifie ladite couche déposée par irradiation sous un rayonnement lumineux
d'une longueur d'onde inférieure ou égale à 200 nm.

2. Procédé selon la revendication 1, **caractérisé en ce que** la densification de la couche d'oxyde s'effectue par irradiation de ladite couche sous un rayonnement lumineux avec une quantité de photons au cm² supérieure à 10¹⁹ et une énergie au moins égale à 9 eV.

3. Procédé selon la revendication 2, **caractérisé en ce que** la longueur d'onde du rayonnement lumineux est d'environ 100 nm.

4. Procédé selon l'une quelconque des revendications 1 à 3, **caractérisé en ce que** la densification de la couche d'oxyde de silicium (23) déposée dans les tranchées (26) a lieu directement après le dépôt de ladite couche avant son aplanissement.

## Claims

1. Method of minimizing the "corner" effect in shallow trenches (26) of silicon oxide for laterally insulating active areas (21), **characterized in that** after depositing a layer (23) of silicon oxide into the trenches (26), said deposited layer is densified by irradiation

2. Method according to claim 1, **characterized in that** the- oxide layer is densified by irradiating said layer with light at a wavelength less than or equal to 200 nm with a number of photons per cm² greater than 10¹⁹ and an energy at least equal to 9 eV.

3. Method according to claim 2, **characterized in that** the wavelength of the light is approximately 100 nm.

4. Method according to any of claims 1 to 3, **characterized in that** the layer (23) of silicon oxide deposited in the trenches (26) is densified directly after depositing said layer, before flattening it.

## Patentansprüche

1. Verfahren zur Minimierung des Randeffekts in wenig tiefen Siliziumoxidgräben (26), das die seitliche Isolierung von aktiven Zonen (21) ermöglicht, **dadurch gekennzeichnet, dass** nach dem Aufbringen einer Siliziumoxidschicht (23) in den Gräben (26) diese aufgebrachte Schicht durch Bestrahlung unter Lichtstrahlung mit einer Wellenlänge von weniger oder gleich 200 nm verdichtet wird.

2. Verfahren nach Anspruch 1, **dadurch gekennzeichnet, dass** die Verdichtung der Oxidschicht durch Bestrahlung der Schicht unter Lichtstrahlung mit einer Photonenmenge pro cm² von mehr als 10¹⁹ und einer Energie von zumindest gleich 9 eV erfolgt.

3. Verfahren nach Anspruch 2, **dadurch gekennzeichnet, dass** die Wellenlänge der Lichtstrahlung ungefähr 100 nm beträgt.

4. Verfahren nach einem der Ansprüche 1 bis 3, **dadurch gekennzeichnet, dass** die Verdichtung der Siliziumoxidschicht (23), die in den Gräben (26) aufgebracht wird, direkt nach der Aufbringung dieser Schicht vor ihrer Abgleichung erfolgt.
